# EUROPÄISCHE PATENTANMELDUNG

(11) **EP 1 903 836 A1**
(43) Veröffentlichungstag der Anmeldung: **26.03.2008**
(21) Anmeldenummer: 07116422.2
(22) Anmeldetag: 14.09.2007
(51) Int. Cl.: H05B 33/08, H05B 39/04, B60L 1/14, G01R 19/00

(54) **Schaltungsanordnung zur Überwachung des Laststromes der Beleuchtungseinrichtung eines Kraftfahrzeuges**

(30) Priorität: 21.09.2006 DE 102006044431
(71) Anmelder: ROBERT BOSCH GMBH, 70442 Stuttgart (DE)
(72) Erfinder: Jehlicka, Joerg, 71229 Leonberg (DE); Wenger, Christoph, 70825 Korntal-Muenchingen (DE); Jauch, Thomas, 70806 Kornwestheim (DE); Roney, Brendan, Glen Iris Victoria 3146 (AU)

(57) **Zusammenfassung**

Die Erfindung betrifft eine Schaltungsanordnung zur Überwachung des Laststromes der Beleuchtungseinrichtung eines Kraftfahrzeuges, welche ein Steuergerät für die Lichtfunktionen sowie eine Schalteinrichtung und eine Messeinrichtung für den sich aus den angeschlossenen Lichtquellen ergebenden Laststrom aufweist. Hierbei ist der Schalteinrichtung (16) für den Laststrom (I) der Beleuchtungseinrichtung eine zusätzliche Stromquelle (IS) zur Erzeugung eines dem Laststrom (I) proportionalen Messstromes (Iₛ) zugeordnet und die Messeinrichtung (18) ist mit einer Messbereichsumschaltung (30) für unterschiedlich hohe Lastströme ausgestattet. Hierdurch kann die Höhe des Messspannungsabfalls beim Anschluss einer kleinen Last angehoben und die Überwachung der Beleuchtungseinrichtung beim Anschluss unterschiedlicher Lichtquellen mit der gleichen Schalt- und Messeinrichtung ausgeführt werden.

## Beschreibung

### Stand der Technik

Die Erfindung geht aus von einer Schaltungsanordnung zur Überwachung des Laststromes der Beleuchtungseinrichtung eines Kraftfahrzeuges nach der Gattung des unabhängigen Anspruchs. Eine derartige Schaltungsanordnung ist aus der DE 101 37 338 A bekannt, welche eine Beleuchtungseinrichtung für ein Kraftfahrzeug mit einer an ein Kraftfahrzeug-Bordnetz anschließbaren Steuereinrichtung zeigt, an der LED-Anordnungen betreibbar sind. Die bekannte Steuereinrichtung ist als Lichtsteuermodul ausgebildet mit einem Mikrocontroller und einem Gleichspannungswandler zur Umsetzung der Kraftfahrzeug-Bordnetzspannung in eine konstante Versorgungsspannung für eine LED-Anordnung. Die Steuereinrichtung erfasst über Stromsensoren die Lastströme mehrerer LED-Anordnungen und überwacht diese auf die Einhaltung des vorgegebenen Nennstromes. Durch die Überwachung der Betriebsströme in den Verbindungsleitungen werden die Funktion der LED-Anordnungen und die Einhaltung der vorgegebenen Leuchtstärke sichergestellt. Die Höhe der Lastströme der einzelnen LED-Anordnungen ist hierbei im Wesentlichen gleich, sodass die verschiedenen LED-Anordnungen durch gleichartige Stromsensoren und durch die gleiche Steuereinrichtung überwacht werden können.

### Offenbarung der Erfindung

Die erfindungsgemäße Schaltungsanordnung ermöglicht es im Unterschied zum zuvor beschriebenen Stand der Technik, mit der gleichen Schalt- und Messeinrichtung unterschiedliche Leuchtquellen der Beleuchtungseinrichtung eines Kraftfahrzeuges zu betreiben und auf ihre Funktion zu überwachen, insbesondere wahlweise an das Steuergerät Glühbirnen oder Leuchtdioden als Lichtquellen anzuschließen, welche stark unterschiedliche Lastströme aufweisen. Dies wird ermöglicht durch die Merkmale des unabhängigen Anspruchs, wobei unterschiedlichen Lastströmen proportionale Messströme unter Verwendung einer Messbereichsumschaltung durch die gleiche Messeinrichtung erfasst werden. Hierdurch wird es beispielsweise möglich, bei unterschiedlichen Ausstattungsvarianten des gleichen Fahrzeugstyps einerseits mit Glühbirnen und andererseits mit Leuchtdioden als Lichtquellen jeweils die gleiche Schaltungsanordnung zur Bereitstellung und zur Überwachung des Laststromes der Beleuchtungseinrichtung des Kraftfahrzeuges zu verwenden.

Die Messeinrichtung der erfindungsgemäßen Schaltungsanordnung besitzt wenigstens zwei parallele Messkreise mit vorzugsweise unterschiedlichen Messwiderständen für den dem Laststrom proportionalen Messstrom, von denen wenigstens einer zu- oder abschaltbar ist. Zweckmäßigerweise wird hierbei der Messkreis mit dem kleinsten Messwiderstand über einen Halbleiterschalter zu- und abgeschaltet, wobei die unterschiedlichen Widerstandswerte der Messwiderstände den Messbereich der Messschaltung bestimmen. Auf diese Weise kann der gleiche A/D-Eingang des Steuergerätes für die Überwachung so unterschiedlicher Lastströme verwendet werden, wie sie beispielsweise bei der alternativen Verwendung von Glühbirnen oder Leuchtdioden mit jeweils der gleichen Leuchtstärke auftreten.

Ein besonders vorteilhafter und einfacher Aufbau der erfindungsgemäßen Schaltungsanordnung der Beleuchtungseinrichtung ergibt sich dadurch, dass als Schaltelement für den Laststrom ein Sense-FET verwendet wird, welcher in einem Bauelement die Schaltfunktion und die Messfunktion für den Laststrom vereinigt, wobei die Messelektrode IS des Sense-FET als Stromquelle zur Erzeugung eines dem Laststrom proportionalen Messstromes dient. Selbstverständlich können jedoch auch getrennte Bauelemente als Schaltglied und Stromquelle zur Erzeugung des Messstromes verwendet werden. Die Schalteinrichtung ist hierbei vorzugsweise als sogenannter High-Side-Schalter zwischen der Versorgungsspannungsquelle und der Last angeordnet, sodass bei geöffnetem Schalter an der jeweiligen Lichtquelle nur Massepotential und nicht das Potential der Versorgungsspannung anliegt.

### Kurze Beschreibung der Zeichnungen

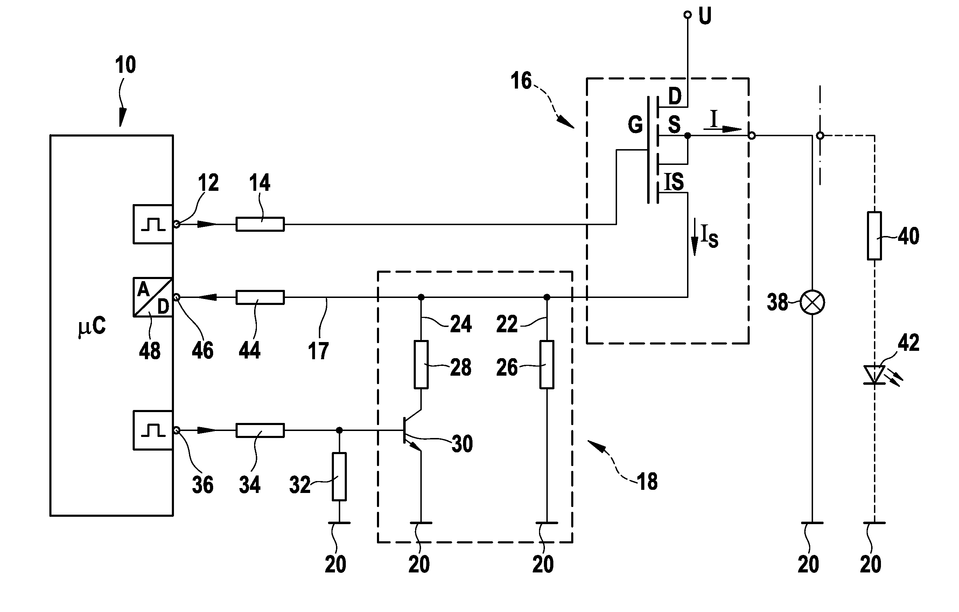

Ein Ausführungsbeispiel der Erfindung ist in der Zeichnung dargestellt und in der nachfolgenden Beschreibung näher erläutert. Die Zeichnung zeigt einen Schaltplan einer Beleuchtungseinrichtung, an welche wahlweise eine oder mehrere Glühbirnen oder eine Leuchtdiodeneinheit als Lichtquelle anschließbar sind.

### Ausführungsform der Erfindung

In der Figur ist mit 10 ein Steuergerät für die Lichtfunktionen der Beleuchtungseinrichtung eines Kraftfahrzeuges bezeichnet, welches als Mikrocontroller ausgebildet ist und von einem Ausgang 12 aus über einen Vorwiderstand 14 eine Schalteinrichtung 16 für die wahlweise anschließbaren Lichtquellen steuert. Die Schalteinrichtung 16 ist als Sense-FET ausgebildet, welcher leistungsmäßig für den Anschluss von einer oder mehreren Glühlampen ausgelegt ist und neben den Elektroden eines herkömmlichen Feldeffekttransistors eine Steuerelektrode IS aufweist, die einen dem Laststrom I proportionalen Messstrom Iₛ liefert. Die Spannungsversorgung der Schaltungsanordnung erfolgt durch die Bordnetzspannung U des Kraftfahrzeuges.

An die den Messstrom Iₛ führende Messleitung 17 der Schalteinrichtung 16 ist eine Messeinrichtung 18 angeschlossen mit zwei parallelen, an der Fahrzeugmasse 20 liegenden Messkreisen 22 und 24. Die Messelektrode IS des Sense-FET bildet eine Stromquelle zur Erzeugung eines dem Laststrom I proportionalen Sensestroms Iₛ, welcher unterschiedliche Spannungsabfälle an unterschiedlich großen Messwiderständen 26 im ersten Messkreis und 28 im zweiten Messkreis erzeugt. Im zweiten Messkreis 24 liegt außerdem ein Halbleiter-Schaltelement in Form eines Transistors 30, dessen Basis über Spannungsteilerwiderstände 32 und 34 einerseits an die Fahrzeugmasse 20 und andererseits an einen weiteren Steuerausgang 36 des Steuergerätes 10 angeschlossen ist.

Als Lichtquellen sind an die Schalteinrichtung 16 wahlweise eine oder mehrere Glühbirnen 38 oder über einen Vorwiderstand 40 eine Leuchtdioden(LED)-Einheit 42 mit einer der benötigten Leuchtstärke entsprechenden Matrixanordnung aus Einzeldioden angeschlossen. Eine derartige unterschiedliche Bestückung der Beleuchtungsanlage eines Fahrzeugs mit unterschiedlichen Lichtquellen ergibt sich beispielsweise bei unterschiedlichen Ausstattungsvarianten des gleichen Fahrzeugtyps, wobei die preiswertere Bestückung mit Glühbirnen häufig in einer Basisversion des Fahrzeugs verwendet wird, während die teurere Bestückung mit Leuchtdioden gehobenen Ausstattungsvarianten des Fahrzeugtyps vorbehalten bleibt. Beide Lichtquellen sollen jedoch an der gleichen Schalteinrichtung 16 betrieben und mit der gleichen Messeinrichtung 16 überwacht werden, in vielen Fällen aus Kostengründen noch parallel zu weiteren Schalteinrichtungen und Verbrauchern. Hierbei besteht insbesondere die Schwierigkeit, eine Leitungsunterbrechung im Beleuchtungskreis von dem sehr kleinen Messstrom I_{S} beim Anschluss einer LED-Einheit 42 sicher zu unterscheiden, wenn die Messeinrichtung 18 gleichzeitig für den sehr viel größeren Messstrom I_{S} beim Anschluss einer Glühbirne 38 ausgelegt werden muss.

Zur Lösung dieses Problems wird die Messeinrichtung 18 erfindungsgemäß mit einer Messbereichsumschaltung für unterschiedlich hohe Lastströme I und entsprechende Messströme Iₛ ausgestattet. Hierzu dienen die beiden parallelen Messkreise 22 und 24, wobei der Messkreis 24 durch den Transistor 30 zu- oder abschaltbar ist. Der an der Messeinrichtung 18 durch den Messstrom Iₛ erzeugte Spannungsabfall wird über einen Widerstand 44 an den Eingang 46 eines in das Steuergerät 10 integrierten A/D-Wandlers angelegt und der Transistor 30 entsprechend der an dem A/D-Wandler 48 anliegenden Eingangsspannung über den Ausgang 36 des Steuergerätes 10 ein- oder ausgeschaltet. Hierbei entspricht das Verhältnis der Widerstandswerte der Widerstände 26 und 28 etwa dem Verhältnis der Leistungsaufnahme einerseits einer Glühbirne 38 und andererseits einer LED-Einheit 42. Beträgt dieses Verhältnis für die Leistungsaufnahme beispielsweise 10:1, so wird zweckmäßigerweise auch das Verhältnis der Widerstände 26 und 28 etwa gleich gewählt. Im dargestellten Ausführungsbeispiel hat der Widerstand 26 einen Widerstandswert von 20kOhm, der Widerstand 28 einen Widerstandswert von 2kOhm. Beim Anschluss einer Glühbirne 38 an die Schalteinrichtung 16 und dem sich hieraus ergebenden höheren Messstrom I_{S} ist der Transistor 30 leitend geschaltet, sodass am AD/Wandler 48 eine im Wesentlichen dem zweiten Messkreis 24 mit dem niederohmigen Messwiderstand 28 entsprechender Spannungsabfall als Steuerspannung anliegt. Andererseits wird der Transistor 30 nicht leitend geschaltet, wenn beim Anschluss einer LED-Einheit 42 an die Schalteinrichtung 16 der Messstrom I_{S} einen wesentlich niedrigeren Wert aufweist als beim Anschluss der Glühbirne 38, wodurch der zweite Messkreis 24 unterbrochen und der Messspannungsabfall durch den höherohmigen Messwiderstand 26 im ersten Messkreis 22 bestimmt wird. Der Messspannungsabfall am Eingang 46 des A/D-Wandlers des Steuergerätes 10 entspricht dann in seiner Größenordnung dem Messwert beim Anschluss einer Glühbirne 38, sodass wiederum ein eindeutiges Messsignal für die Beleuchtungseinrichtung vorliegt. Der Anschluss einer LED-Einheit 42 mit sehr geringer Leistungsaufnahme kann hierdurch deutlich von einer Unterbrechung im Lastkreis unterschieden werden. Außerdem kann der Einfluss verschiedener anderer Störgrößen weitgehend ausgeschaltet werden, beispielsweise der Einfluss herstellungsbedingter Toleranzen der Leistungsschalter, des A/D-Wandlers, des Mikroprozessors und/oder der Messwiderstände.

## Patentansprüche

1. Schaltungsanordnung zur Überwachung des Laststromes (I) der Beleuchtungseinrichtung eines Kraftfahrzeuges, mit einem Steuergerät (10) für die Lichtfunktionen sowie mit einer Schalteinrichtung (16) und einer Messeinrichtung (18) für den Laststrom (I), **dadurch gekennzeichnet, dass** in die Schalteinrichtung (16) für den Laststrom (I) der Beleuchtungseinrichtung eine Stromquelle (IS) zur Erzeugung eines dem Laststrom (I) proportionalen Messstromes (I_{S}) integriert ist und dass die Messeinrichtung (18) eine Messbereichsumschaltung (24,28,30) für unterschiedlich hohe Lastströme (I) aufweist.

2. Schaltungsanordnung nach Anspruch 1, **dadurch gekennzeichnet, dass** die Beleuchtungseinrichtung als Lichtquellen wahlweise wenigstens eine Glühbirne (38) oder wenigstens eine Leuchtdiode (42) aufweist.

3. Schaltungsanordnung nach Anspruch 1 oder 2, **dadurch gekennzeichnet, dass** die Messeinrichtung (18) wenigstens zwei parallele Messkreise (22,24) mit vorzugsweise unterschiedlichen Messwiderständen (26,28) aufweist, von denen wenigstens einer (28) zu- oder abschaltbar ist.

4. Schaltungsanordnung nach Anspruch 3, **dadurch gekennzeichnet, dass** der Messkreis (24) mit dem kleinsten Messwiderstand (28) über einen Halbleiterschalter (30) zu- und abschaltbar ist.

5. Schaltungsanordnung nach einem der vorhergehenden Ansprüche, **dadurch gekennzeichnet, dass** die Messbereichsumschaltung (24,28,30) durch das Steuergerät (10) für die Lichtfunktionen erfolgt.

6. Schaltungsanordnung nach einem der vorhergehenden Ansprüche, **dadurch gekennzeichnet, dass** der Ausgangswert der Messeinrichtung (18) einem Analog/Digital(A/D)-Eingang (46) des Steuergerätes (10) zugeführt wird.

7. Schaltungsanordnung nach einem der vorhergehenden Ansprüche, **dadurch gekennzeichnet, dass** die Schalteinrichtung (16) für den Laststrom (I) als Sense-FET ausgebildet ist und als Stromquelle (I_{S}) den Messausgang (IS) des Sense-FET verwendet.

8. Schaltungsanordnung nach einem der vorhergehenden Ansprüche, **dadurch gekennzeichnet, dass** die Schalteinrichtung (16) für den Laststrom (I) zwischen der Last (38,42) und der Versorgungsspannungsquelle (U) angeordnet ist (High-Side-Schalter).

9. Schaltungsanordnung nach einem der vorhergehenden Ansprüche, **dadurch gekennzeichnet, dass** das Steuergerät (10) für die Lichtfunktionen als Mikrocontroller mit integriertem A/D-Wandler (48) ausgebildet ist.
